# EUROPEAN PATENT APPLICATION

(11) **EP 2 466 647 A2**
(43) Date of publication of application: **20.06.2012**
(21) Application number: 10808300.7
(22) Date of filing: 30.07.2010
(51) Int. Cl.: H01L 31/042, H01L 31/048

(54) **DYE-SENSITIVE SOLAR CELL AND MODULE CONSISTING OF SAME**

(30) Priority: 11.08.2009 KR 20090073584
(71) Applicant: Dongjin Semichem Co., Ltd., Seo-gu Incheon 404-205 (KR)
(72) Inventor: BAE, Ho-gi, Gyeonggi-Do 451-781 (KR); KIM, Jong-bok, Seoul 138-172 (KR); AN, Hyun-Cheol, Gyeonggi-Do 445-931 (KR); LEE, Kee-Doo, Gyeonggi-Do 445-935 (KR)
(74) Representative: Merkle, Gebhard
(86) International application number: PCT/KR2010/005034
(87) International publication number: WO 2011/019151

(57) **Abstract**

The invention relates to a dye-sensitized solar cell and a module using the same and more particularly, to a dye-sensitized solar cell in which a photoelectrode substrate and a catalyst electrode substrate are spaced apart from each other by a separating space and coupled together by an encapsulating material and the separating space is filled with an electrolyte, **characterized in that** the electrolyte contains optical beads, and a module using the same.

Thus, light passing through the photoelectrode substrate is refracted or reflected by the optical beads, and irradiated onto the photoelectrode substrate, thereby to improve the efficiency of the solar cell. Particularly, the efficiency of a dye-sensitized solar cell for a BIPV system is more effectively improved, said solar cell not having a separate scattering layer for maintaining the translucency thereof. If the optical beads are colored, solar cells with a variety of colors can be obtained, which achieves an aesthetic enhancement for a building adopting the BIPV system.

## Description

### FIELD OF THE INVENTION

The present invention relates to a dye-sensitized solar cell and a module using the same and more particularly, to a dye-sensitized solar cell wherein light passing through a photoelectrode substrate is refracted or reflected by optical beads, and irradiated onto the photoelectrode substrate, thereby to improve the efficiency of the solar cell; particularly, the efficiency of a dye-sensitized solar cell for a BIPV system is more effectively improved, said solar cell not having a separate scattering layer for maintaining the translucency thereof; and if the optical beads are colored, solar cells with a variety of colors can be obtained, which achieves an aesthetic enhancement for a building adopting the BIPV system, and a module using the same.

### BACKGROUND OF THE INVENTION

Since a dye-sensitized nanoparticle titanium oxide solar cell was developed by Michael Gratzel et al. of Swiss Federal Institute of Technology Lausanne (EPFL) in 1991, many studies on this field are under progress. As the dye-sensitized solar cell has remarkably low manufacturing costs compared to the existing silicon solar cells, it has a potential of replacing the existing amorphous silicon solar cells. Unlike the silicon solar cells, the dye-sensitized solar cell is a photoelectrochemical solar cell mainly comprising a dye molecule capable of absorbing visible rays to generate an electron-hole pair, and a transition metal oxide for transmitting the generated electrons.

Generally, a unit cell for a dye-sensitized solar cell comprises, as a basic structure, transparent top and bottom substrates, and conductive transparent electrodes each formed on the surfaces of the transparent substrates, wherein on one conductive transparent electrode, which corresponds to a photoelectrode (first electrode), a transition metal oxide multi-porous layer adsorbed with a dye on the surface thereof is formed; on the other conductive transparent electrode, which corresponds to a catalyst electrode (second electrode), a catalyst thin-film electrode is formed; the transition metal oxide, for example, TiO₂ multi-porous electrode and the catalyst thin-film electrode are spaced apart by a certain gap to form space, which is filled with an electrolyte; and the gap is enclosed by an encapsulating material to store the electrolyte.

In case of general dye-sensitized solar cells, transparency is not required for the installation of solar cells. Therefore, in order to increase the efficiency of the solar cells, it is common to have a scattering layer on the side of the photoelectrode substrate facing the separating space (corresponding to the back side of the photoelectrode substrate), which functions as sending light passing through the photoelectrode substrate back to the photoelectrode substrate.

Photovoltaic energy generates electricity and provides it to consumers. Building-integrated photovoltaic modules have been used as building windows or exterior materials to reduce construction costs, to enable the buildings themselves to generate power, and to raise the value of the buildings due to their environment-friendly design nature. The dye-sensitized solar cells that are applied to a BIPV (Building Integrated PhotoVoltaic) system do not add the scattering layer during the preparation thereof so as to function as building windows that are transparent, and their photoelectric conversion efficiency is thus decreased.

Furthermore, even in case of the modules which do not require transparency, they use an expensive TiO₂ scattering layer and thus increase raw material costs. In addition, the preparation of the scattering layer involves a complicated process.

Therefore, there are demands on the development of a dye-sensitized solar cell capable of addressing the above problems and a solar cell module using it.

### SUMMARY OF THE INVENTION

Accordingly, it is an object of the invention to provide a dye-sensitized solar cell wherein light passing through a photoelectrode substrate is refracted or reflected by optical beads, and irradiated onto the photoelectrode substrate, thereby to improve the efficiency of the solar cell; particularly, the efficiency of a dye-sensitized solar cell for a BIPV system is more effectively improved, said solar cell not having a separate scattering layer for maintaining the translucency thereof; and if the optical beads are colored, solar cells with a variety of colors can be obtained, which achieves an aesthetic enhancement for a building adopting the BIPV system, and a module using the same.

In order to achieve the objects, the present invention provides a dye-sensitized solar cell in which a photoelectrode substrate and a catalyst electrode substrate are spaced apart from each other by a separating space and coupled together by an encapsulating material and the separating space is filled with an electrolyte, **characterized in that** the electrolyte contains optical beads.

Also, the invention provides a dye-sensitized solar cell in which a photoelectrode substrate and a catalyst electrode substrate are spaced apart from each other by a separating space and coupled together by an encapsulating material and the separating space is filled with an electrolyte, characterized by further comprising a scattering layer formed by coating a paste containing optical bead onto the side of the photoelectrode substrate facing the separating space.

Further, the present invention provides a dye-sensitized solar cell module formed by integrating the dye-sensitized solar cell.

According to the dye-sensitized solar cell and the module using the same of the present invention, light passing through the photoelectrode substrate is refracted or reflected by the optical beads, and irradiated onto the photoelectrode substrate, thereby to improve the efficiency of the solar cell; particularly, the efficiency of a dye-sensitized solar cell for a BIPV system is more effectively improved, said solar cell not having a separate scattering layer for maintaining the translucency thereof; and if the optical beads are colored, solar cells with a variety of colors can be obtained, which achieves an aesthetic enhancement for a building adopting the BIPV system.

In the past, where transparent dye-sensitized solar cells were manufactured, efficiency increase had limitations because a large amount of light passed through. However, if optical beads are sprinkled and dispersed in the space filled with the electrolyte solution in the present invention, they increase the amount of light that dye molecules encounter by scattering light that affects the efficiency and dies, while not having significant influences on transparency, thereby to cause the efficiency increase.

Also, since beads having a variety of sizes may be used, they may be chosen to function as a spacer for maintaining a certain interval between the top substrate and the bottom substrate as the size of modules is increased.

Further, in the past, the manufacturing of dye-sensitized solar cells involved a sintering process of 500°C or above TiO₂ to form a scattering layer of about 300-400 nm size in order to increase the photoelectric conversion efficiency thereof and it required the use of expensive materials. However, the present invention utilizes as a material for the scattering layer inexpensive optical beads that have been already massively produced, and thus it can reduce manufacturing costs. For the formation of the scattering layer to increase scattering effects, a paste capable of forming optical beads at temperatures not higher than 300 °C can be prepared and coated. Thus, as film formation is carried out at low temperatures compared to the existing technique, a bending issue of glass substrates is remarkably improved.

Although the existing dye-sensitized solar cells are **characterized in that** they could express several colors, such various color expression was not possible with maintaining the same properties. However, in the present invention, it is possible to adsorb a variety of colors to melamine resins in the optical beads, without altering main dyes that determine the efficiency. Thus, as the color of the scattering layer formed on the back side or the electrolyte is adjustable, the present invention enables to express various colors without change in efficiency.

### BRIEF DESCRIPTION OF THE DRAWINGS

Fig. 1 is a schematic cross-sectional view illustrating one embodiment of a dye-sensitized solar cell containing optical beads according to the present invention.
Fig. 2 is a schematic cross-sectional view illustrating another embodiment of a dye-sensitized solar cell containing optical beads according to the present invention.
Fig. 3 is a schematic cross-sectional view illustrating another embodiment of a dye-sensitized solar cell containing optical beads according to the present invention.
Fig. 4 is an enlarged view of a dye-sensitized solar cell containing optical beads according to the present invention, schematically illustrating the mechanism of the optical beads inside the electrolyte.
Fig. 5 is a schematic cross-sectional view illustrating one embodiment of a dye-sensitized solar cell containing optical beads according to the present invention, which comprises a scattering layer containing the optical beads.
Fig. 6 is an enlarged view of a dye-sensitized solar cell containing optical beads according to the present invention, which comprises a scattering layer containing the optical beads, schematically illustrating the mechanism of the optical beads inside in the scattering layer.

| | |
|---|---|
| 10a: Top glass substrate | 10b: Bottom glass substrate |
| 20: Photoelectrode | 30: Catalyst electrode |
| 40: Electrolyte | 50: Encapsulating material |
| 60: Optical beads | 70: Scattering layer |

### DETAILED DESCRIPTION OF THE INVENTION

Hereinafter, the present invention is described in detail.

The dye-sensitized solar cell of the present invention comprises a photoelectrode substrate (10a + 20) and a catalyst substrate (10b + 30) which are spaced apart from each other by a separating space and coupled together by an encapsulating material (50), and an electrolyte (40) which is filled in the separating space, wherein the electrolyte (40) contains optical beads (60).

A detailed description regarding each component will be made with reference to the drawings.

The dye-sensitized solar cell of the present invention is configured such that a photoelectrode substrate (10a + 20) and a catalyst substrate (10b + 30) are spaced apart from each other by a separating space and coupled together by an encapsulating material (50), and the separating space is filled with an electrolyte (40), and it may include any common dye-sensitized solar cells or a dye-sensitized solar cell applied to a BIPV system.

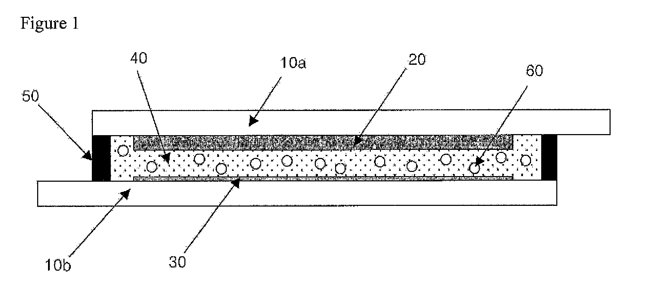

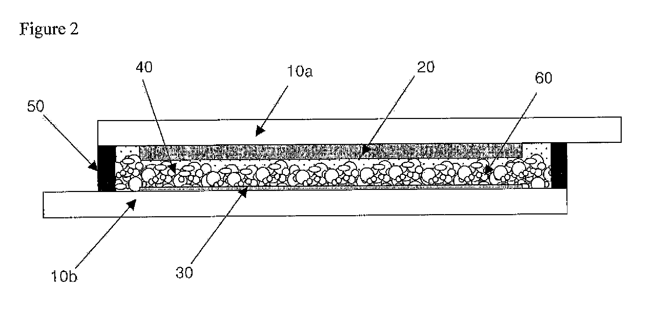

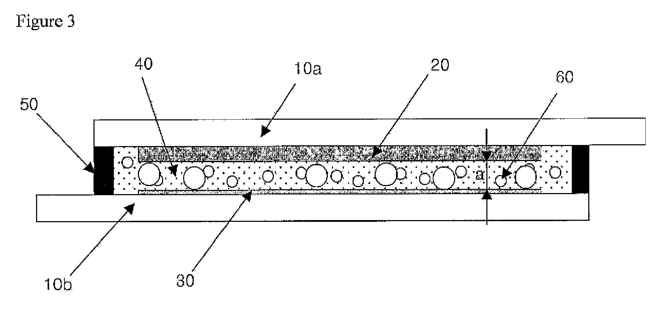

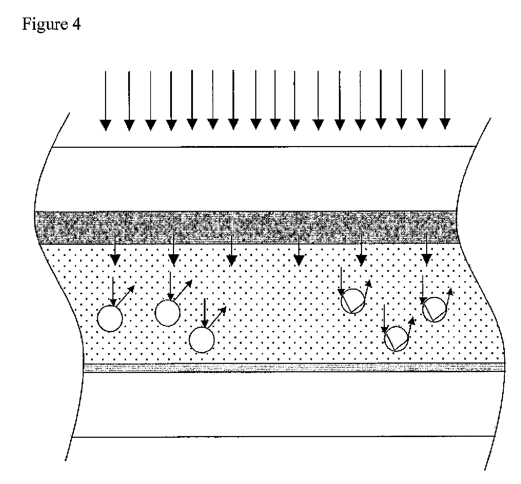

The electrolyte contains optical beads (60), and its specific embodiments are as shown in Fig. 1 to Fig. 3. Thus, the electrolyte may be a liquid electrolyte, gel phase electrolyte, polymer solid electrolyte, inorganic solid electrolyte, etc. and preferably, it may be a liquid electrolyte to secure transparency in dye-sensitized solar cells for a BIPV system. The optical beads are dispersed in the electrolyte. As shown in Fig. 4, some of light that is incident onto a dye-sensitized solar cell is absorbed to the photoelectrode substrate, and light that is not absorbed and passes through is reflected or refracted by the optical beads, and then irradiated back onto the photoelectrode substrate. Thus, this reabsorption process may help enhance the efficiency (in Fig. 4, the left part illustrates a reabsorption process induced by reflection, and the right part illustrates a reabsorption process induced by refraction). In other words, the optical beads help enhance the efficiency by reflecting or refracting the light which is incident onto the dye-sensitized solar cell and then incident onto the optical beads, toward the photoelectrode substrate.

The optical beads, in the case of a liquid electrolyte, may be included in an electrolyte solution by blending with the electrolyte before or after the injection of the electrolyte, or in the case of other solid phase or gel phase, they may be dispersed in the solid phase or gel phase by mixing them together during the preparation thereof. The size of the optical beads may be equal as shown in Fig. 1, or they may be used in combination of a variety of beads in terms of size and shape (sphere, oval, polyhedron, cylinder, polyprism, etc.). Preferably, the beads may have diameters of 30 µm to 100 µm.

Meanwhile, the optical beads may be concentrated on the bottom if the dye-sensitized solar cell containing the liquid phase electrolyte is disposed in its standing position. Therefore, in order to prevent this happening and make reflection or refraction occur evenly, the beads may be constituted as the following configuration.

First, the total volume of the optical beads may be preferably at least 70% of the space to be filled with the electrolyte. The total volume of the optical beads as used herein refers to a volume comprising the net volume of the optical beads and the gap volume between them. The beads filled by this volume, even in the case that the beads are concentrated on the bottom, enable comparatively even reflection or refraction throughout the entire area to be obtained, thereby increasing the efficiency improvement effects and reducing the charge amount of the electrolyte without affecting the efficiency thereof.

Alternatively, the diameter of the optical beads may be preferably at least 70% of the direction interval (a) between the photoelectrode substrate and the catalyst electrode substrate in the space to be filled with the electrolyte. The beads having such a large size may remarkably reduce the cornering problems of the beads to the bottom caused by the stacking thereof, and enable comparatively even reflection or refraction throughout the entire area to be obtained, thereby increasing the efficiency improvement effects.

Further, the specific gravity of the optical beads may be adjusted to be identical to the specific gravity of the electrolyte so that the optical beads may be evenly dispersed without being concentrated either on the top or bottom. For this, the optical beads may be constructed to have a hollow part in the center of them, or the concentration of the electrolyte solution may be adjusted.

In addition to the reflection or refraction functions, as the optical beads are disposed in the direction interval between the photoelectrode substrate and the catalyst electrode substrate in the space to be filled with the electrolyte, they may perform as a spacer for maintaining the interval between the two substrates. For this purpose, the diameter of the optical beads may be preferably at least 70% of the direction interval (a) between the photoelectrode substrate and the catalyst electrode substrate in the space to be filled with the electrolyte.

The optical beads may be any particles in any shapes as long as they are stable in electrolytes and are able to reflect or refract light and preferably, they may be those particles having a high reflection rate or high refraction rate. Their specific examples may include glass beads, PMMA beads, melamine resin beads, glass beads coated with substances that are stable in electrolyte and have a high reflection rate, such as platinum or gold, PMMA beads coated with substances that are stable in electrolyte and have a high reflection rate, such as platinum or gold, melamine resin beads coated with substances that are stable in electrolyte and have a high reflection rate, such as platinum or gold, ceramic beads coated with substances that are stable in electrolyte and have a high reflection rate, such as platinum or gold, metal beads coated with substances that are stable in electrolyte and have a high reflection rate, such as platinum or gold, and so on, and preferably, such beads may be colored to express a variety of colors in case that the dye-sensitized solar cell is applied to a transparent dye-sensitized solar cell for a BIPV system having no scattering layer.

Preferably, the optical beads may be OPTBEADS (registered trademark) by Nissan Chemical Industries, Ltd. The OPTBEADS, according to its disclosure, has a structure of a spherical body of melamine resins in the inside, of which the surface is thinly coated with silica and the outer surface of which is then coated again with melamine resins, and it has a high refraction rate of about 1.65 and thus induces re-incident of incident light onto the photoelectrode. More particularly, the melamine resins of the optical beads OPTBEAD by Nissan Chemical Industries, Ltd may be further colored to express a variety of colors.

Also, the present invention provides, as an efficiency improvement method using the optical beads, a dye-sensitized solar cell in which a photoelectrode substrate and a catalyst electrode substrate are spaced apart from each other by a separating space and coupled together by an encapsulating material and the separating space is filled with an electrolyte, characterized by further comprising a scattering layer (70) formed by coating a paste containing optical beads (60) onto the side of the photoelectrode substrate facing the separating space.

Where a dye-sensitized solar cell is not used for a BIPV system, it may add a scattering layer on the side of the photoelectrode substrate facing the separating space (that is, the hidden side of the photoelectrode substrate). For this, a TiO₂ scattering layer of 300∼400 nm size is generally formed, but it involves the coating of expensive materials such as titanium dioxide and a sintering process at high temperatures of 500 °C or above. However, if the paste dispersed with the optical beads as in the present invention is coated, it is possible to form a scattering layer at a low temperature with low cost, thereby to remarkably improve a bending issue of the glass substrates.

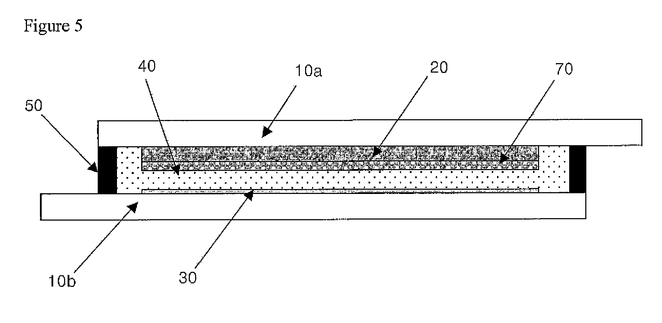

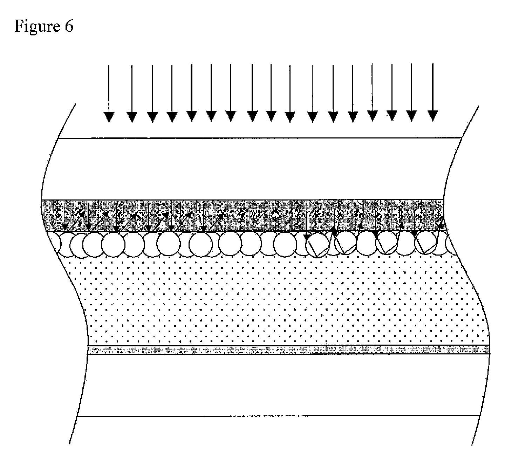

A specific example of the dye-sensitized solar cell with the scattering layer formed therein is as shown in Fig. 5, and the efficiency improvement mechanism thereof is shown in Fig. 6. In this figure, the left part illustrates a reabsorption process induced by reflection, and the right part illustrates a reabsorption process induced by reflection.

The optical beads as used herein may be the same as the beads described in the above, and they may be colored as well to express a variety of colors of the scattering layer.

Furthermore, the present invention provides a dye-sensitized solar cell module formed by integrating the dye-sensitized solar cell as described in the above and preferably, the dye-sensitized solar cell module formed by integrating the dye-sensitized solar cell may be applied to a BIPV system.

Although the present invention may be applied to all the conventional dye-sensitized solar cell modules, efficiency improvement by the optical beads is remarkable particularly in the transparent dye-sensitized solar cell modules having no scattering layer for BIPV systems. It is to be understood that the integration of the dye-sensitized solar cells to the modules may be performed using ordinary methods and structures.

It is to be understood that the invention as stated in the above is not limited by the aforementioned detailed description and the embodiments, and various modifications and alterations made by those skilled in the pertinent art within the spirit and scope of the invention defined by the following claims are still within the scope of the invention.

## Claims

1. A dye-sensitized solar cell in which a photoelectrode substrate and a catalyst electrode substrate are spaced apart from each other by a separating space and coupled together by an encapsulating material and the separating space is filled with an electrolyte, **characterized in that** the electrolyte contains optical beads.

2. The dye-sensitized solar cell of Claim 1, wherein the electrolyte is an electrolyte solution, and the total volume of the optical beads is at least 70% of the space to be filled with the electrolyte.

3. The dye-sensitized solar cell of Claim 1, wherein the diameter of the optical beads is at least 70% of the direction interval between the photoelectrode substrate and the catalyst electrode substrate in the space to be filled with the electrolyte, and the optical beads perform as a spacer between the photoelectrode substrate and the catalyst electrode substrate.

4. The dye-sensitized solar cell of Claim 1, wherein the electrolyte is an electrolyte solution, and the specific gravity of the optical beads are identical to the specific gravity of the electrolyte.

5. A dye-sensitized solar cell in which a photoelectrode substrate and a catalyst electrode substrate are spaced apart from each other by a separating space and coupled together by an encapsulating material and the separating space is filled with an electrolyte, **characterized by** further comprising a scattering layer formed by coating a paste containing optical bead onto the side of the photoelectrode substrate facing the separating space.

6. The dye-sensitized solar cell of Claim 1 or Claim 5, wherein the optical beads reflect or refract the light which is incident onto the dye-sensitized solar cell and then incident onto the optical beads, toward the photoelectrode substrate.

7. The dye-sensitized solar cell of Claim 6, wherein the optical beads are OPTBEADS by Nissan Chemical Industries, Ltd.

8. The dye-sensitized solar cell of Claim 7, wherein the melamine resins in the optical beads OPTBEAD by Nissan Chemical Industries, Ltd. are colored.

9. A dye-sensitized solar cell module formed by integrating the dye-sensitized solar cell of Claim 1 or Claim 4.

10. A dye-sensitized solar cell module formed by integrating the dye-sensitized solar cell of Claim 1, **characterized in that** the dye-sensitized solar cell module is applied to a BIPV system.
